# EUROPEAN PATENT APPLICATION

(11) **EP 4 596 286 A1**
(43) Date of publication of application: **06.08.2025**
(21) Application number: 22963978.6
(22) Date of filing: 03.11.2022
(51) Int. Cl.: B60K 11/02

(54) **ELECTRONIC CONTROL UNIT, CONTROL SYSTEM, AND TERMINAL**

(71) Applicant: Shenzhen Yinwang Intelligent Technologies Co., Ltd., Shenzhen, Guangdong 518129 (CN)
(72) Inventor: WANG, Xiaofei, Shenzhen, Guangdong 518129 (CN)
(74) Representative: Pfenning, Meinig & Partner mbB
(86) International application number: PCT/CN2022/129676
(87) International publication number: WO 2024/092668

(57) **Abstract**

An electronic control unit, a control system, and a terminal are provided, and relate to the field of vehicles. The control system includes a first ECU and a second ECU, the first ECU includes a liquid cooling structure, and the second ECU does not include a liquid cooling structure. The first ECU and the second ECU each include at least two fastening interfaces, the at least two fastening interfaces are configured to install fasteners, and the fasteners are configured to fasten the first ECU and the second ECU together. The fastening interfaces are provided on the ECU without the liquid cooling structure and the ECU with the liquid cooling structure, and the two ECUs are fastened together through the fastening interfaces, to share the liquid cooling structure of the ECU with the liquid cooling structure. There is no need to introduce an additional independent liquid cooling plate, provided that the ECU with the liquid cooling structure is connected to a water path of a thermal management system. Introduction of additional independent liquid cooling plates is reduced in the water path of the thermal management system, so that complexity of the thermal management system can be reduced.

## Description

### TECHNICAL FIELD

This application relates to the field of vehicles, and in particular, to an electronic control unit, a control system, and a terminal.

### BACKGROUND

An electronic control unit (electronic control unit, ECU) is also referred to as a "vehicle computer", a "vehicle-mounted computer", or the like. In terms of uses, the ECU is a microcomputer controller of a terminal, and in the field of vehicles, the ECU may also be referred to as a vehicle-specific single-chip microcomputer. Some ECUs can be connected to a thermal management apparatus to form a thermal management system (thermal management system, TMS) with the thermal management apparatus, to ensure that the ECUs work in an environment with a suitable temperature.

As vehicles become more intelligent, a quantity of vehicle-mounted ECUs increases sharply, and power consumption of the ECUs also increases significantly. For some ECUs of high power consumption that require active heat dissipation, currently known design solutions include: An ECU can have a liquid cooling structure, connected to a thermal management apparatus of a vehicle, to perform cooling and heat dissipation. Alternatively, an independent liquid cooling plate is externally disposed, an ECU is fastened to the liquid cooling plate, and the liquid cooling plate is connected to a thermal management apparatus of a vehicle, to perform cooling and heat dissipation on the ECU fastened to the liquid cooling plate. When there are a large quantity of ECUs without a liquid cooling structure and ECUs with a liquid cooling structure, a water path connection in a thermal management system is complex, and system maintenance is difficult.

### SUMMARY

This application provides an electronic control unit, a control system, and a terminal, to reduce complexity of a thermal management system, and further reduce difficulty in system maintenance.

According to a first aspect, this application provides a control system. The system includes a first ECU and a second ECU, the first ECU includes a liquid cooling structure, and the second ECU does not include a liquid cooling structure. The first ECU and the second ECU each include at least two fastening interfaces, the at least two fastening interfaces are configured to install fasteners, and the fasteners are configured to fasten the first ECU and the second ECU together.

According to the foregoing solution, the fastening interfaces are provided on the ECU without the liquid cooling structure and the ECU with the liquid cooling structure, and the ECU without the liquid cooling structure and the ECU with the liquid cooling structure are fastened together through the fastening interfaces, to share the liquid cooling structure of the ECU with the liquid cooling structure. There is no need to introduce an additional independent liquid cooling plate, provided that the ECU with the liquid cooling structure is connected to a water path of a thermal management system. Introduction of additional independent liquid cooling plates is reduced in the water path of the thermal management system, so that complexity of the thermal management system can be reduced, and difficulty in system maintenance can be reduced. In addition, there is no need to purchase an additional independent liquid cooling plate, so that costs can be reduced.

Optionally, the liquid cooling structure of the first ECU includes a cavity configured to contain a coolant, and a liquid inlet and a liquid outlet that communicate with the cavity; and the liquid cooling structure and the first ECU are integrally formed.

That the liquid cooling structure and the first ECU are integrally formed may also be understood as follows: The liquid cooling structure is a non-detachable part of the first ECU.

With reference to the first aspect, in some possible designs, the first ECU further includes at least one thermally conductive groove, the thermally conductive groove is located on an outer surface of the cavity, an opening of the thermally conductive groove faces the second ECU, the thermally conductive groove is configured to contain a thermally conductive material, and the thermally conductive material is configured to conduct heat.

The thermally conductive material includes but is not limited to a thermally conductive pad, a thermally conductive gel, and the like. This is not limited in this application.

With reference to the first aspect, in some possible designs, the first ECU and the second ECU communicate with each other through a communication channel, and the communication channel includes a controller area network (controller area network, CAN) bus, a CAN with flexible data-rate (flexible data-rate, FD) bus, Ethernet, or a wireless network.

The second ECU and the first ECU may communicate with each other through the CAN bus, the CAN FD bus, the Ethernet, or the wireless network. In other words, the second ECU and the first ECU may be physically connected to each other through the CAN bus or the CAN FD bus, or may be physically connected to each other through an Ethernet network cable, or may be wirelessly connected to each other through the wireless network. This is not limited in this application.

With reference to the first aspect, in some possible designs, the first ECU is configured to obtain a temperature of the second ECU from the second ECU through the communication channel.

The ECU without the liquid cooling structure and the ECU with the liquid cooling structure that are fastened together may be considered as a whole, and the first ECU and the second ECU may communicate with each other through the communication channel. Based on this, there is no need for the second ECU to be in an internal communication connection to a thermal management apparatus, provided that the first ECU is in a communication connection to the thermal management apparatus. This can reduce complexity of a communication connection in the thermal management system to some extent, and further reduce difficulty in system maintenance.

Optionally, the system further includes a thermal management apparatus, the liquid cooling structure of the first ECU is connected to the thermal management apparatus, and the thermal management apparatus is configured to control a target temperature and/or a target flow rate of a coolant flowing out of the thermal management apparatus.

The thermal management apparatus may also include a liquid inlet and a liquid outlet. For example, the liquid inlet of the liquid cooling structure of the first ECU may communicate with the liquid outlet of the thermal management apparatus, and the liquid outlet of the liquid cooling structure of the first ECU may communicate with the liquid inlet of the thermal management apparatus, so that the coolant circulates between the thermal management apparatus and the liquid cooling structure of the first ECU, to ensure that the first ECU and the second ECU in the control system work in an environment with a suitable temperature.

With reference to the first aspect, in some possible designs, the first ECU is further configured to report indication information of a required temperature and/or a required flow rate of the coolant to the thermal management apparatus based on a temperature of the first ECU and the temperature of the second ECU. The thermal management apparatus is specifically configured to: receive indication information reported by a plurality of first ECUs; and control the target temperature and/or the target flow rate based on the received plurality of pieces of indication information.

With reference to the first aspect, in some possible designs, the first ECU is further configured to report a temperature of the first ECU and the temperature of the second ECU to the thermal management apparatus. The thermal management apparatus is specifically configured to: receive temperatures reported by a plurality of first ECUs; and control the target temperature and/or the target flow rate based on the received plurality of temperatures.

According to a second aspect, this application provides a first ECU. The first ECU includes a liquid cooling structure, the first ECU includes at least two fastening interfaces for installing fasteners, and the fasteners are configured to fasten the first ECU and a second ECU that does not include a liquid cooling structure together.

According to the foregoing solution, the fastening interfaces are provided on the ECU with the liquid cooling structure, and the ECU without the liquid cooling structure and the ECU with the liquid cooling structure are fastened together through the fastening interfaces. In other words, the ECU without the liquid cooling structure and the ECU with the liquid cooling structure that are fastened together may be considered as a whole, to share the liquid cooling structure of the ECU with the liquid cooling structure. There is no need to introduce an additional independent liquid cooling plate, provided that the ECU with the liquid cooling structure is connected to a water path of a thermal management system. Introduction of additional independent liquid cooling plates is reduced in the water path of the thermal management system, so that complexity of the thermal management system can be reduced. In addition, there is no need to purchase an additional independent liquid cooling plate, so that costs can be reduced.

Optionally, the liquid cooling structure includes a cavity configured to contain a coolant, and a liquid inlet and a liquid outlet that communicate with the cavity; and the liquid cooling structure and the first ECU are integrally formed.

With reference to the second aspect, in some possible designs, the first ECU further includes at least one thermally conductive groove, the thermally conductive groove is located on an outer surface of the cavity, the thermally conductive groove is configured to contain a thermally conductive material, and the thermally conductive material is configured to conduct heat.

With reference to the second aspect, in some possible designs, the first ECU is configured to obtain a temperature of the second ECU.

According to a third aspect, this application provides a second ECU. The second ECU does not include a liquid cooling structure, the second ECU includes at least two fastening interfaces for installing fasteners, and the fasteners are configured to fasten the second ECU and a first ECU including a liquid cooling structure together.

According to the foregoing solution, the fastening interfaces are provided on the ECU without the liquid cooling structure, and the ECU without the liquid cooling structure and the ECU with the liquid cooling structure are fastened together through the fastening interfaces. In other words, the ECU without the liquid cooling structure and the ECU with the liquid cooling structure that are fastened together may be considered as a whole, to share the liquid cooling structure of the ECU with the liquid cooling structure. There is no need to introduce an additional independent liquid cooling plate, provided that the ECU with the liquid cooling structure is connected to a water path of a thermal management system. Introduction of additional independent liquid cooling plates is reduced in the water path of the thermal management system, so that complexity of the thermal management system can be reduced. In addition, there is no need to purchase an additional independent liquid cooling plate, so that costs can be reduced.

According to a fourth aspect, this application provides a terminal. The terminal includes the control system according to any one of the first aspect or the first aspect.

Optionally, the terminal includes a vehicle.

It should be understood that, technical solutions of the fourth aspect of this application correspond to those of the first aspect to the third aspect of this application. Beneficial effects achieved by these aspects and corresponding feasible implementations are similar, and details are not described again.

### BRIEF DESCRIPTION OF DRAWINGS

FIG. 1 is a diagram of a thermal management system;
FIG. 2 is a diagram of a first ECU according to an embodiment of this application;
FIG. 3 is a comparison diagram of different sizes of a second ECU adapted to a first ECU according to an embodiment of this application;
FIG. 4 is a diagram of a second ECU according to an embodiment of this application;
FIG. 5 is a diagram of a control system according to an embodiment of this application; and
FIG. 6 is a diagram of a terminal according to an embodiment of this application.

### DESCRIPTION OF EMBODIMENTS

The following describes technical solutions of this application with reference to accompanying drawings.

For ease of clearly describing the technical solutions in embodiments of this application, the following descriptions are first provided.

First, in embodiments of this application, terms such as "first" and "second" are used to distinguish between same items or similar items that have basically same functions or purposes. For example, a first ECU and a second ECU are used to distinguish between different ECUs, and do not limit a sequence thereof. A person skilled in the art may understand that the terms such as "first" and "second" do not limit a quantity and an execution sequence, and the terms such as "first" and "second" do not indicate a definite difference.

Second, in embodiments of this application, "at least one" means one or more. The term "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between associated objects, but does not exclude an "and" relationship between the associated objects. A specific meaning indicated by the character "/" may be understood with reference to the context.

Third, in embodiments of this application, the terms "include", "have", and any other variants thereof are intended to cover non-exclusive inclusion. For example, a process, method, system, product, or device that includes a series of steps or units is not necessarily limited to those steps or units that are expressly listed, but may include other steps or units that are not expressly listed or are inherent to the process, method, product, or device.

Terms used in this application are first briefly described.
1. ECU: An ECU is also referred to as a "vehicle computer", a "vehicle-mounted computer", or the like. Like a common computer, the ECU includes a microcontroller unit (microcontroller unit, MCU), a memory, an input/output interface, an analog-to-digital converter, and large-scale integrated circuits such as a shaping circuit and a drive circuit. A normal working temperature of the ECU ranges from -40 degrees Celsius (degree Celsius, °C) to 80°C.
2. CAN bus: A CAN bus is an example of an in-vehicle communication link. The CAN bus is a type of serial communication network that effectively supports distributed control or realtime control. The CAN bus is used for a connection between components of a vehicle. For example, the CAN bus may connect components including a CAN controller chip, a data receiver, a data transmitter, and the like.
3. Fastener (fastener): A fastener may also be referred to as a standard fastener or a standard part, and is a general term for mechanical parts used when two or more parts (or components) are fastened together to form a whole. There are various types and specifications of fasteners with different performance and uses, and the fasteners are highly standardized, serialized, and universalized.

The fastener includes but is not limited to the following parts:
Bolt: A bolt is a type of fastener that includes a head and a threaded rod (a cylinder with external threads), and is used with a nut to fasten two parts that have a through hole together. Such a connection form is referred to as a bolt connection. The two parts may be separated by unscrewing the nut from the bolt, and therefore the bolt connection is a detachable connection.

Stud: Different from a bolt, a stud has no head and is a type of fastener with external threads at both ends. During connection, one end of the stud needs to be screwed into a part that has an inner threaded hole, the other end of the stud passes through a part that has a through hole, and a nut is screwed, so that the two parts are fastened together to form a whole. Such a connection form is referred to as a stud connection, and is also a detachable connection. The stud is mainly used in a scenario in which one of to-be-connected parts is thick and a compact structure is required, or a bolt connection is not suitable due to frequent detachment.

Screw: A screw is a type of fastener that includes a head and a threaded rod. Screws may be classified into three types according to uses: machine screws, set screws, and specialpurpose screws. A screw may be used with a nut or without a nut. For example, when a screw is used to fasten a part that has a set threaded hole to a part that has a through hole, the screw is used without a need for a nut, and when a screw is used to fasten two parts that have a through hole together, the screw needs to be used with a nut. Such a connection form is referred to as a screw connection, and is also a detachable connection.

Self-tapping screw: A self-tapping screw is also referred to as a quick thread screw, and is a quick-install fastener that is made of steel and that has a galvanized passivated surface. The self-tapping screw is often used to connect thin metal plates (such as steel plates and saw plates). During connection, a threaded bottom hole needs to be made to a to-be-connected part, and then the self-tapping screw is screwed into the threaded bottom hole of the to-be-connected part.

Wood screw: A wood screw is similar to a machine screw, but threads on a threaded rod of the wood screw are dedicated threads of the wood screw. The wood screw may be directly screwed into a wood component (or part), and is used to fasten a metal (or non-metal) part that has a through hole to a wood component. Such a connection is a detachable connection.

Rivet: A rivet is a type of fastener that includes a head and a rod, and is used to fasten two parts (or components) that have a hole together to form a whole. Such a connection form is referred to as a rivet connection, which is briefly referred to as riveting, and is a non-detachable connection. A rivet on two parts that are connected together by using the rivet needs to be broken to separate the parts.

Welding stud: A welding stud is a short term for a cheese head stud for arc stud welding. The welding stud is a fastener for a high strength and rigidity connection, and may include a rod and a head, or may not include a head. The welding stud is fastened to a part (or component) in a welding method, to facilitate a connection to another part.

Pin: A pin is mainly used to position a part. Some pins may alternatively be used to connect parts, fasten a part, transfer power, lock a fastener, or the like.

In addition, in an actual application scenario, the bolt, the stud, the screw, or the like described above may be used with a nut, a washer, a retaining ring, or the like. This is not limited in embodiments of this application.

Nut: A nut has an inner threaded hole, and a shape of the nut includes but is not limited to a flat hexagonal prism shape, a flat square prism shape, or a flat cylinder shape. The nut is used with a bolt, a stud, a screw, or the like to fasten two parts together to form a whole.

Washer: A washer is a type of fastener whose shape includes but is not limited to a flat ring shape. The washer may be placed between a supporting surface of a bolt, a screw, or a nut and a surface of a connected part, to increase a contact surface area of the connected part, reduce pressure per unit area, and protect the surface of the connected part from being damaged. Another type is an elastic washer, which can further prevent a nut from loosening.

Retaining ring: A retaining ring is installed in a shaft slot or a shaft hole slot of a machine or a device, to prevent a part on a shaft or a hole from moving left or right.

As vehicles become more intelligent, a quantity of vehicle-mounted ECUs increases sharply, and power consumption of the ECUs also increases significantly. For some ECUs of high power consumption that require active heat dissipation, currently known design solutions include the following two solutions: In a first solution, an ECU can have a liquid cooling structure (for ease of description, such an ECU is briefly referred to as an ECU with a liquid cooling structure in this application), and the ECU with the liquid cooling structure can be directly connected to a thermal management apparatus of a vehicle, to perform cooling and heat dissipation. In a second solution, an independent liquid cooling plate is externally disposed, an ECU that does not have a liquid cooling structure (for ease of description, such an ECU is briefly referred to as an ECU without a liquid cooling structure in this application) is fastened to the liquid cooling plate, and the liquid cooling plate is connected to a thermal management apparatus of a vehicle, to perform cooling and heat dissipation on the ECU without the liquid cooling structure that is fastened to the liquid cooling plate.

In other words, a vehicle may include an ECU without a liquid cooling structure and an ECU with a liquid cooling structure. Some ECUs of low power consumption without a liquid cooling structure do not generate much heat, and the ECUs can be ensured to work in an environment with a suitable temperature through heat dissipation perform by the ECUs. Some ECUs of high power consumption without a liquid cooling structure generate high heat, and the ECUs cannot be ensured to work in an environment with a suitable temperature through heat dissipation performed by only the ECUs. Therefore, the ECUs of high power consumption without the liquid cooling structure need to be connected to a thermal management apparatus, to ensure that the ECUs work in an environment with a suitable temperature.

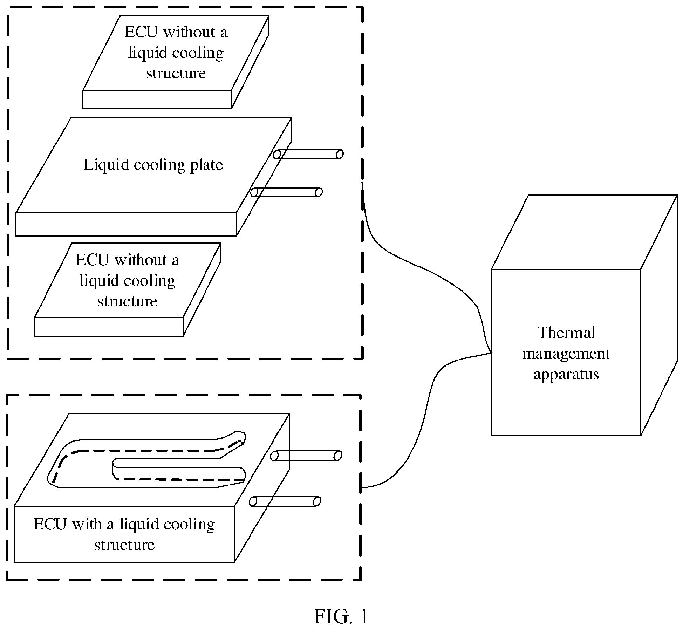

FIG. 1 is a diagram of a thermal management system. As shown in FIG. 1, an ECU with a liquid cooling structure may be directly connected to a thermal management apparatus of an entire vehicle, to become a part of a thermal management system of the vehicle. An ECU without a liquid cooling structure needs to be fastened to an independent liquid cooling plate, and then connected to the thermal management apparatus of the entire vehicle, to become a part of the thermal management system. When there are a large quantity of ECUs without a liquid cooling structure and ECUs with a liquid cooling structure, liquid cooling plates to which the ECUs without the liquid cooling structure are fastened need to be connected to a water path of the thermal management system, and the ECUs with the liquid cooling structure also need to be connected to the water path of the thermal management system, resulting in a complex water path connection in the thermal management system. In addition, the ECUs without the liquid cooling structure and the ECUs with the liquid cooling structure need to communicate with the thermal management apparatus in the thermal management system. Consequently, a communication connection in the thermal management system is also complex, and system maintenance is difficult.

In view of the foregoing problem, embodiments of this application provide an electronic control unit, a control system, and a terminal. Fastening interfaces are provided on an ECU without a liquid cooling structure and an ECU with a liquid cooling structure, and the ECU without the liquid cooling structure and the ECU with the liquid cooling structure are fastened together through the fastening interfaces, to share the liquid cooling structure of the ECU with the liquid cooling structure. There is no need to introduce an additional independent liquid cooling plate, provided that the ECU with the liquid cooling structure is connected to a water path of a thermal management system. Introduction of additional independent liquid cooling plates is reduced in the water path of the thermal management system, so that complexity of the thermal management system can be reduced, and difficulty in system maintenance can be reduced. In addition, there is no need to purchase an additional independent liquid cooling plate, so that costs can be reduced.

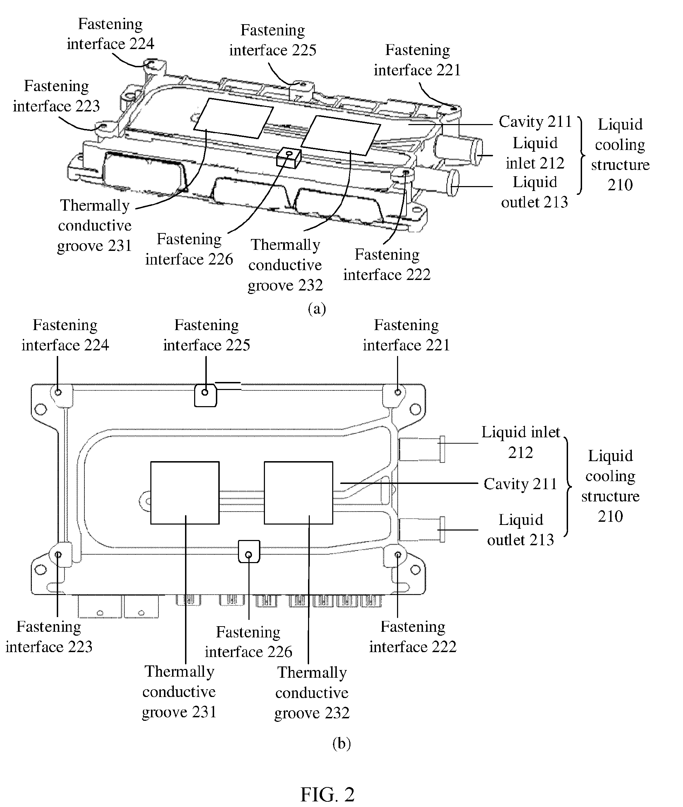

The following first describes in detail a first ECU and a second ECU provided in this application with reference to FIG. 2 to FIG. 4.

FIG. 2 is a diagram of a first ECU according to an embodiment of this application.

An embodiment of this application provides a first ECU. The first ECU includes a liquid cooling structure, the first ECU includes at least two fastening interfaces for installing fasteners, and the fasteners are configured to fasten the first ECU and a second ECU that does not include a liquid cooling structure together.

As mentioned above, the fastener is a general term for mechanical parts used when two or more parts (or components) are fastened together to form a whole. There are various types and specifications of fasteners with different performance and uses, and the fasteners are highly standardized, serialized, and universalized. In an actual application scenario, the fastening interface may be provided according to different requirements. A specific form of the fastening interface corresponds to the fastener, and forms of fastening interfaces suitable for different types of fasteners may be different. This is not limited in embodiments of this application.

For example, as shown in FIG. 2, (a) in FIG. 2 is a three-dimensional diagram of the first ECU, and (b) in FIG. 2 is a top view of the first ECU in (a) in FIG. 2. The first ECU includes a liquid cooling structure 210 and a plurality of fastening interfaces, for example, a fastening interface 221, a fastening interface 222, a fastening interface 223, a fastening interface 224, a fastening interface 225, and a fastening interface 226.

At least two fastening interfaces in the fastening interfaces included in the first ECU may be aligned with at least two fastening interfaces in fastening interfaces included in the second ECU, so that the second ECU can be fastened to the first ECU.

As an example instead of a limitation, as shown in (b) in FIG. 2, positions of the fastening interface 221, the fastening interface 224, and the fastening interface 225 may be connected to form a straight line. In other words, the positions of the fastening interface 221, the fastening interface 224, and the fastening interface 225 are on one straight line. Positions of the fastening interface 222, the fastening interface 223, and the fastening interface 226 cannot be connected to form a straight line. In other words, the positions of the fastening interface 222, the fastening interface 223, and the fastening interface 226 are not on one straight line. In this way, second ECUs of different sizes may be fastened to the first ECU through the fastening interface 221, the fastening interface 222, the fastening interface 223, the fastening interface 224, the fastening interface 225, and the fastening interface 226, so that universality is good.

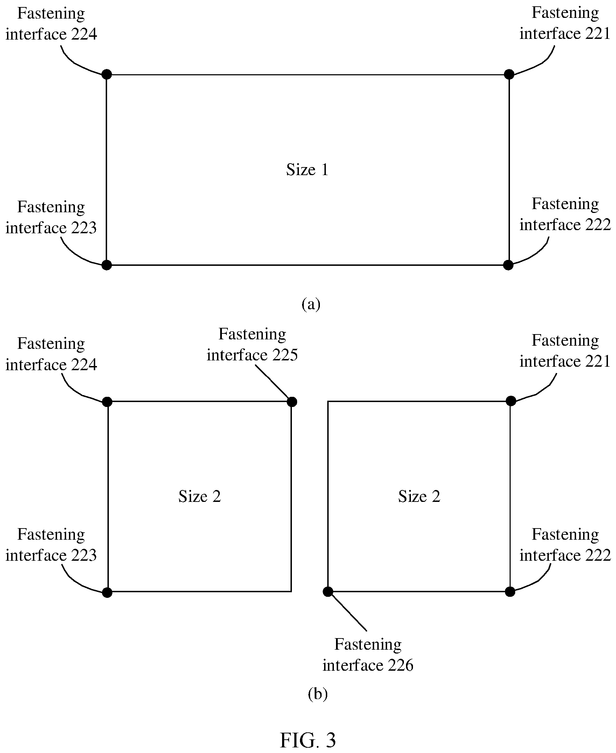

The following describes different sizes of the second ECU that can be adapted to the first ECU provided in this embodiment of this application with reference to FIG. 3.

FIG. 3 is a comparison diagram of different sizes of a second ECU adapted to a first ECU according to an embodiment of this application.

Example 1: As shown in (a) in FIG. 3, a second ECU of a size 1 may be fastened to the first ECU through the fastening interface 221 and the fastening interface 223, or the fastening interface 222 and the fastening interface 224, or the fastening interface 221, the fastening interface 222, and the fastening interface 223, or the fastening interface 221, the fastening interface 222, and the fastening interface 224, or the fastening interface 222, the fastening interface 223, and the fastening interface 224, or the fastening interface 221, the fastening interface 224, and the fastening interface 223, or the fastening interface 221, the fastening interface 222, the fastening interface 223, and the fastening interface 224.

Example 2: As shown in (b) in FIG. 3, a second ECU of a size 2 may be fastened to the first ECU through the fastening interface 223 and the fastening interface 225, or the fastening interface 221 and the fastening interface 226, or the fastening interface 221, the fastening interface 222, and the fastening interface 226, or the fastening interface 223, the fastening interface 224, and the fastening interface 225.

It may be understood that one second ECU of the size 1 may be fastened to one first ECU, or one or two second ECUs of the size 2 may be fastened to one first ECU. This is not limited in embodiments of this application.

It should be understood that the size 1 and the size 2 are not sizes in a strict sense, and are merely intended to distinguish between second ECUs of different sizes (or specifications), and shall not be construed as any limitation on this application.

FIG. 2 and FIG. 3 are merely examples. In an actual application scenario, the first ECU may include more or fewer fastening interfaces, provided that the second ECU can be ensured to be fastened to the first ECU. A specific quantity of fastening interfaces included in the first ECU is not limited in embodiments of this application.

Optionally, the liquid cooling structure of the first ECU includes a cavity configured to contain a coolant, and a liquid inlet and a liquid outlet that communicate with the cavity; and the liquid cooling structure and the first electronic control unit are integrally formed.

As an example instead of a limitation, as shown in FIG. 2, the liquid cooling structure 210 of the first ECU may include a cavity 211, a liquid inlet 212, and a liquid outlet 213. A coolant may enter the cavity 211 from the liquid inlet 212, and then flow out of the cavity 211 from the liquid outlet 213. The liquid cooling structure 210 and the first ECU are integrally formed. In other words, the liquid cooling structure 210 is a non-detachable part of the first ECU.

In a possible design, the first ECU further includes at least one thermally conductive groove, the thermally conductive groove is located on an outer surface of the cavity, the thermally conductive groove is configured to contain a thermally conductive material, and the thermally conductive material is configured to conduct heat.

As an example instead of a limitation, as shown in FIG. 2, the first ECU may further include a thermally conductive groove 231 and a thermally conductive groove 232. Before the first ECU and the second ECU are fastened together by using the fasteners, the thermally conductive material may be placed in the thermally conductive groove, to better conduct heat between the first ECU and the second ECU. The thermally conductive material includes but is not limited to a thermally conductive pad, a thermally conductive gel, and the like. This is not limited in embodiments of this application.

In a possible design, the first ECU is configured to obtain a temperature of the second ECU.

The first ECU may obtain a temperature of the first ECU, and the second ECU may obtain a temperature of the second ECU. The first ECU and the second ECU may communicate with each other, so that the first ECU can obtain the temperature of the second ECU from the second ECU, to perform subsequent processing based on the temperature of the first ECU and the temperature of the second ECU.

The ECU without the liquid cooling structure and the ECU with the liquid cooling structure that are fastened together may be considered as a whole, and the first ECU and the second ECU may perform internal communication with each other through a communication channel (for example, the first ECU obtains the temperature of the second ECU). Based on this, there is no need for the second ECU to be in a communication connection to a thermal management apparatus, provided that the first ECU is in a communication connection to the thermal management apparatus. This can reduce complexity of a communication connection in a thermal management system to some extent, and further reduce difficulty in system maintenance.

According to the foregoing solution, the fastening interfaces are provided on the ECU with the liquid cooling structure, and the ECU without the liquid cooling structure and the ECU with the liquid cooling structure are fastened together through the fastening interfaces. In other words, the ECU without the liquid cooling structure and the ECU with the liquid cooling structure that are fastened together may be considered as a whole, to share the liquid cooling structure of the ECU with the liquid cooling structure. There is no need to introduce an additional independent liquid cooling plate, provided that the ECU with the liquid cooling structure is connected to a water path of the thermal management system. Introduction of additional independent liquid cooling plates is reduced in the water path of the thermal management system, so that complexity of the thermal management system can be reduced. In addition, the ECU without the liquid cooling structure and the ECU with the liquid cooling structure that are fastened together may be considered as a whole, and the first ECU and the second ECU may perform internal communication with each other through the communication channel. Based on this, there is no need for the second ECU to be in a communication connection to the thermal management apparatus, provided that the first ECU is in a communication connection to the thermal management apparatus. This can reduce complexity of a communication connection in the thermal management system to some extent, and further reduce difficulty in system maintenance. In addition, when complexity of a water path connection and the communication connection in the thermal management system is reduced, for an entire vehicle, space occupied by the thermal management system can be reduced. In addition, there is no need to purchase an additional independent liquid cooling plate, so that costs can be reduced.

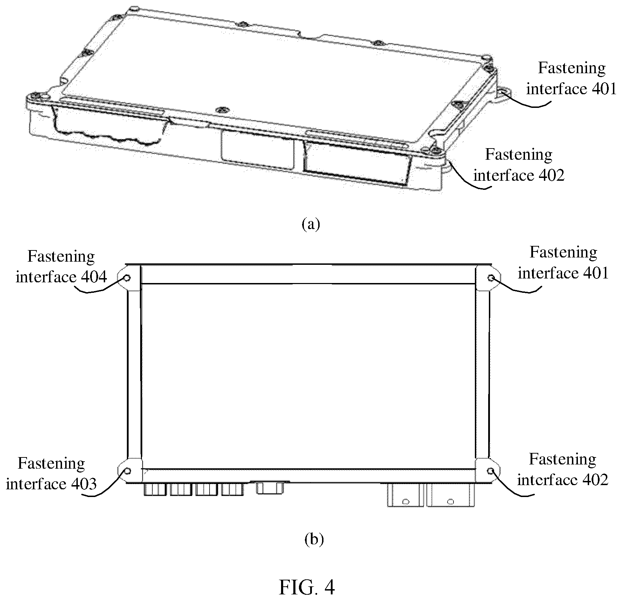

FIG. 4 is a diagram of a second ECU according to an embodiment of this application.

An embodiment of this application provides a second ECU. The second ECU does not include a liquid cooling structure, the second ECU includes at least two fastening interfaces for installing fasteners, and the fasteners are configured to fasten the second ECU and the first ECU including the liquid cooling structure together.

For detailed descriptions of the fastening interface and the fastener, refer to the foregoing descriptions. For brevity, details are not described herein again.

For example, as shown in FIG. 4, (a) in FIG. 4 is a three-dimensional diagram of the second ECU, and (b) in FIG. 4 is a bottom view of the second ECU in (a) in FIG. 4. The second ECU includes a plurality of fastening interfaces, for example, a fastening interface 401, a fastening interface 402, a fastening interface 403, and a fastening interface 404.

At least two fastening interfaces in the fastening interfaces included in the second ECU may be aligned with at least two fastening interfaces in the fastening interfaces included in the first ECU, so that the second ECU can be fastened to the first ECU.

As described above, second ECUs of different sizes may be fastened to the first ECU provided in embodiments of this application. In other words, in an actual application scenario, second ECUs of different sizes may be included.

Example 1: For example, a size of the second ECU is the size 1 shown in (a) in FIG. 3. The following are several possible design manners for the second ECU of the size 1.

Design manner 1: The second ECU may include the fastening interface 401 and the fastening interface 403 shown in (b) in FIG. 4. In this case, the fastening interface 401 and the fastening interface 403 of the second ECU may be aligned with the fastening interface 221 and the fastening interface 223 of the first ECU, so that the second ECU of the size 1 can be fastened to the first ECU.

Design manner 2: The second ECU may include the fastening interface 402 and the fastening interface 404 shown in (b) in FIG. 4. In this case, the fastening interface 402 and the fastening interface 404 of the second ECU may be aligned with the fastening interface 222 and the fastening interface 224 of the first ECU, so that the second ECU of the size 1 can be fastened to the first ECU.

Design manner 3: The second ECU may include the fastening interface 401, the fastening interface 402, and the fastening interface 403 shown in (b) in FIG. 4. In this case, the fastening interface 401, the fastening interface 402, and the fastening interface 403 of the second ECU may be aligned with the fastening interface 221, the fastening interface 222, and the fastening interface 223 of the first ECU, so that the second ECU of the size 1 can be fastened to the first ECU.

Design manner 4: The second ECU may include the fastening interface 401, the fastening interface 402, and the fastening interface 404 shown in (b) in FIG. 4. In this case, the fastening interface 401, the fastening interface 402, and the fastening interface 404 of the second ECU may be aligned with the fastening interface 221, the fastening interface 222, and the fastening interface 224 of the first ECU, so that the second ECU of the size 1 can be fastened to the first ECU.

Design manner 5: The second ECU may include the fastening interface 402, the fastening interface 403, and the fastening interface 404 shown in (b) in FIG. 4. In this case, the fastening interface 402, the fastening interface 403, and the fastening interface 404 of the second ECU may be aligned with the fastening interface 222, the fastening interface 223, and the fastening interface 224 of the first ECU, so that the second ECU of the size 1 can be fastened to the first ECU.

Design manner 6: The second ECU may include the fastening interface 401, the fastening interface 404, and the fastening interface 403 shown in (b) in FIG. 4. In this case, the fastening interface 401, the fastening interface 404, and the fastening interface 403 of the second ECU may be aligned with the fastening interface 221, the fastening interface 224, and the fastening interface 223 of the first ECU, so that the second ECU of the size 1 can be fastened to the first ECU.

Design manner 7: The second ECU may include the fastening interface 401, the fastening interface 402, the fastening interface 403, and the fastening interface 404 shown in (b) in FIG. 4. In this case, the fastening interface 401, the fastening interface 402, the fastening interface 403, and the fastening interface 404 of the second ECU may be aligned with the fastening interface 221, the fastening interface 222, the fastening interface 223, and the fastening interface 224 of the first ECU, so that the second ECU of the size 1 can be fastened to the first ECU.

Example 2: For example, a size of the second ECU is the size 2 shown in (a) in FIG. 3. The following are several possible design manners for the second ECU of the size 2.

Design manner 1: The second ECU may include the fastening interface 401 and the fastening interface 403 shown in (b) in FIG. 4. In this case, the fastening interface 401 and the fastening interface 403 of the second ECU may be aligned with the fastening interface 223 and the fastening interface 225 of the first ECU, or may be aligned with the fastening interface 221 and the fastening interface 226 of the first ECU, so that the second ECU of the size 1 can be fastened to the first ECU.

Design manner 2: The second ECU may include the fastening interface 402 and the fastening interface 404 shown in (b) in FIG. 4. In this case, the fastening interface 402 and the fastening interface 404 of the second ECU may be aligned with the fastening interface 223 and the fastening interface 225 of the first ECU, or may be aligned with the fastening interface 221 and the fastening interface 226 of the first ECU, so that the second ECU of the size 1 can be fastened to the first ECU.

Design manner 3: The second ECU may include the fastening interface 401, the fastening interface 402, and the fastening interface 403 shown in (b) in FIG. 4. In this case, the fastening interface 401, the fastening interface 402, and the fastening interface 403 of the second ECU may be aligned with the fastening interface 221, the fastening interface 222, and the fastening interface 223 of the first ECU, or may be aligned with the fastening interface 223, the fastening interface 224, and the fastening interface 225 of the first ECU, so that the second ECU of the size 1 can be fastened to the first ECU.

Design manner 4: The second ECU may include the fastening interface 401, the fastening interface 404, and the fastening interface 403 shown in (b) in FIG. 4. In this case, the fastening interface 401, the fastening interface 404, and the fastening interface 403 of the second ECU may be aligned with the fastening interface 221, the fastening interface 222, and the fastening interface 223 of the first ECU, or may be aligned with the fastening interface 223, the fastening interface 224, and the fastening interface 225 of the first ECU, so that the second ECU of the size 1 can be fastened to the first ECU.

Design manner 5: The second ECU may include the fastening interface 401, the fastening interface 404, and the fastening interface 402 shown in (b) in FIG. 4. In this case, the fastening interface 401, the fastening interface 404, and the fastening interface 402 of the second ECU may be aligned with the fastening interface 221, the fastening interface 222, and the fastening interface 223 of the first ECU, or may be aligned with the fastening interface 223, the fastening interface 224, and the fastening interface 225 of the first ECU, so that the second ECU of the size 1 can be fastened to the first ECU.

Design manner 6: The second ECU may include the fastening interface 402, the fastening interface 403, and the fastening interface 404 shown in (b) in FIG. 4. In this case, the fastening interface 402, the fastening interface 403, and the fastening interface 404 of the second ECU may be aligned with the fastening interface 221, the fastening interface 222, and the fastening interface 223 of the first ECU, or may be aligned with the fastening interface 223, the fastening interface 224, and the fastening interface 225 of the first ECU, so that the second ECU of the size 1 can be fastened to the first ECU.

It may be understood that FIG. 4 is merely an example. In an actual application scenario, the second ECU may include more or fewer fastening interfaces, provided that the second ECU can be ensured to be fastened to the first ECU. A specific quantity of fastening interfaces included in the second ECU is not limited in embodiments of this application.

According to the foregoing solution, the fastening interfaces are provided on the ECU without the liquid cooling structure, and the ECU without the liquid cooling structure and the ECU with the liquid cooling structure are fastened together through the fastening interfaces. In other words, the ECU without the liquid cooling structure and the ECU with the liquid cooling structure that are fastened together may be considered as a whole, to share the liquid cooling structure of the ECU with the liquid cooling structure. There is no need to introduce an additional independent liquid cooling plate, provided that the ECU with the liquid cooling structure is connected to the water path of the thermal management system. Introduction of additional independent liquid cooling plates is reduced in the water path of the thermal management system, so that complexity of the thermal management system can be reduced. In addition, there is no need to purchase an additional independent liquid cooling plate, so that costs can be reduced.

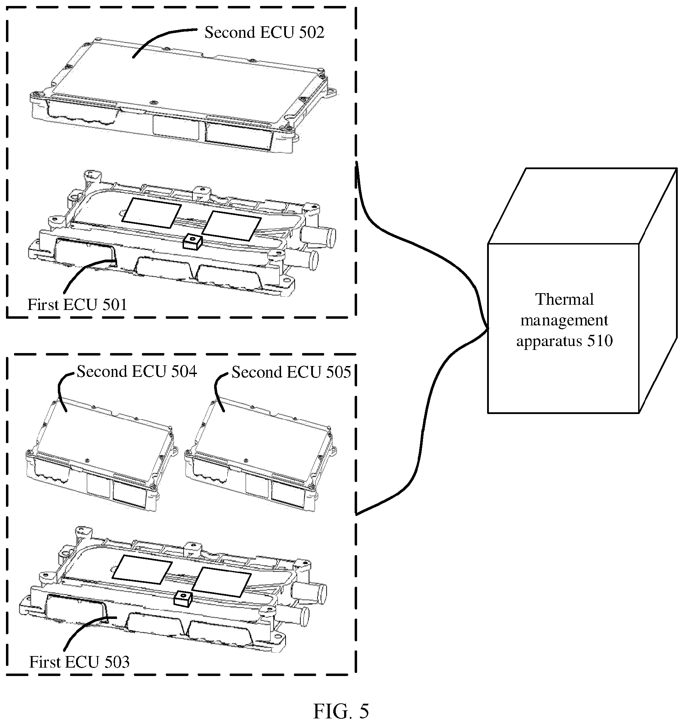

The following describes in detail a control system provided in this application with reference to FIG. 5.

This application further provides a control system. The system includes a first ECU and a second ECU, the first ECU includes a liquid cooling structure, and the second ECU does not include a liquid cooling structure. The first ECU and the second ECU each include at least two fastening interfaces, the at least two fastening interfaces are configured to install fasteners, and the fasteners are configured to fasten the first ECU and the second ECU together.

It may be understood that one or more second ECUs may be fastened to a surface on which the liquid cooling structure of the first ECU is located. This is not limited in embodiments of this application.

FIG. 5 is a diagram of a control system according to an embodiment of this application. As shown in FIG. 5, the system includes a first ECU 501, a second ECU 502, a first ECU 503, a second ECU 504, and a second ECU 505. The second ECU 502 may be fastened to the first ECU 501 through fastening interfaces. The second ECU 504 and the second ECU 505 may be fastened to the first ECU 503 through fastening interfaces.

As an example instead of a limitation, a size of the second ECU 502 may be the size 1 described above, and sizes of the second ECU 504 and the second ECU 505 may be the size 2 described above. This is not limited in embodiments of this application.

For example, the first ECU 501 and the first ECU 503 may include the fastening interface 221, the fastening interface 222, the fastening interface 223, the fastening interface 224, the fastening interface 225, and the fastening interface 226 shown in FIG. 2.

For how to fasten the second ECU 502 to the first ECU 501 and how to fasten the second ECU 504 and the second ECU 505 to the first ECU 503, refer to FIG. 3 and descriptions related to FIG. 3. For brevity, details are not described herein again.

Optionally, the liquid cooling structure of the first ECU includes a cavity configured to contain a coolant, and a liquid inlet and a liquid outlet that communicate with the cavity; and the liquid cooling structure and the first electronic control unit are integrally formed.

For related descriptions of the liquid cooling structure, refer to the foregoing related descriptions. For brevity, details are not described herein again.

In a possible design, the first ECU further includes at least one thermally conductive groove, the thermally conductive groove is located on an outer surface of the cavity, an opening of the thermally conductive groove faces the second ECU, the thermally conductive groove is configured to contain a thermally conductive material, and the thermally conductive material is configured to conduct heat.

For related descriptions of the thermally conductive groove, refer to the foregoing related descriptions. For brevity, details are not described herein again.

In a possible implementation, the first ECU and the second ECU communicate with each other through a communication channel, and the communication channel includes a CAN bus, a CAN FD bus, Ethernet, or a wireless network.

For example, as shown in FIG. 5, the second ECU 502 is fastened to the first ECU 501, and the second ECU 504 and the second ECU 505 are fastened to the first ECU 503. Communication between the second ECU 502 and the first ECU 501, between the second ECU 504 and the first ECU 503, and between the second ECU 505 and the first ECU 503 may be performed through a CAN bus, a CAN FD bus, Ethernet, or a wireless network. In other words, a physical connection between the second ECU 502 and the first ECU 501, between the second ECU 504 and the first ECU 503, and between the second ECU 505 and the first ECU 503 may be implemented through a CAN bus or a CAN FD bus, or may be implemented through an Ethernet network cable, or a wireless connection between the second ECU 502 and the first ECU 501, between the second ECU 504 and the first ECU 503, and between the second ECU 505 and the first ECU 503 may be implemented through a wireless network. This is not limited in embodiments of this application.

In a possible implementation, the first ECU is configured to obtain a temperature of the second ECU from the second ECU through the communication channel.

As described above, the first ECU may obtain a temperature of the first ECU, and the second ECU may obtain a temperature of the second ECU. The first ECU and the second ECU may communicate with each other through the communication channel, so that the first ECU can obtain the temperature of the second ECU from the second ECU, to perform subsequent processing based on the temperature of the first ECU and the temperature of the second ECU.

The ECU without the liquid cooling structure and the ECU with the liquid cooling structure that are fastened together may be considered as a whole, and the first ECU and the second ECU may perform internal communication with each other through the communication channel (for example, the first ECU obtains the temperature of the second ECU). Based on this, there is no need for the second ECU to be in an internal communication connection to a thermal management apparatus, provided that the first ECU is in a communication connection to the thermal management apparatus. As shown in FIG. 5, the first ECU 501 may obtain a temperature of the first ECU 501, and obtain a temperature of the second ECU 502 from the second ECU 502 through a communication channel between the first ECU 501 and the second ECU 502. The first ECU 503 may obtain a temperature of the first ECU 503, obtain a temperature of the second ECU 504 from the second ECU 504 through a communication channel between the first ECU 503 and the second ECU 504, and obtain a temperature of the second ECU 505 from the second ECU 505 through a communication channel between the first ECU 503 and the second ECU 505. Then, the first ECU 501 and the first ECU 503 communicate with the thermal management apparatus, and there is no need for the second ECU 502, the second ECU 504, and the second ECU 505 to communicate with the thermal management apparatus. This can reduce complexity of a communication connection in a thermal management system to some extent, and further reduce difficulty in system maintenance.

Optionally, the control system further includes the thermal management apparatus, the liquid cooling structure of the first ECU is connected to the thermal management apparatus, and the thermal management apparatus is configured to control a target temperature and/or a target flow rate of a coolant flowing out of the thermal management apparatus.

For example, as shown in FIG. 5, the control system includes a thermal management apparatus 510. Liquid cooling structures of the first ECU 501 and the first ECU 503 may be connected to the thermal management apparatus. The thermal management apparatus may be configured to control a target temperature and/or a target flow rate of a coolant flowing out of the thermal management apparatus.

It should be understood that FIG. 5 is merely an example. In an actual application scenario, the control system may include more or fewer first ECUs, and may include more or fewer second ECUs. This is not limited in embodiments of this application.

Although not shown in FIG. 5, the thermal management apparatus may also include a liquid inlet and a liquid outlet. For example, liquid inlets of the liquid cooling structures of the first ECU 501 and the first ECU 503 may communicate with the liquid outlet of the thermal management apparatus 510, and liquid outlets of the liquid cooling structures of the first ECU 501 and the first ECU 503 may communicate with the liquid inlet of the thermal management apparatus 510, so that the coolant circulates between the thermal management apparatus and the liquid cooling structure of the first ECU, to ensure that the first ECU and the second ECU in the control system work in an environment with a suitable temperature.

It may be understood that the control system including the thermal management apparatus is the thermal management system (TMS) described above.

In a possible implementation, the first ECU is further configured to report indication information of a required temperature and/or a required flow rate of the coolant to the thermal management apparatus based on the temperature of the first ECU and the temperature of the second ECU. The thermal management apparatus is specifically configured to: receive indication information reported by a plurality of first ECUs; and control the target temperature and/or the target flow rate based on the received plurality of pieces of indication information.

The indication information may include the required temperature and/or the required flow rate, or may not include the required temperature and/or the required flow rate. Specific content included in the indication information is not limited in embodiments of this application, provided that the required temperature and/or the required flow rate can be obtained based on the indication information.

For example, after the first ECU obtains the temperature of the first ECU and the temperature of the second ECU, the first ECU may determine the required temperature and/or the required flow rate of the coolant based on the temperature of the first ECU and the temperature of the second ECU, generate the indication information of the required temperature and/or the required flow rate of the coolant, and report the indication information to the thermal management apparatus.

For example, after obtaining the temperature of the first ECU 501 and the temperature of the second ECU 502, the first ECU 501 may determine a required temperature and/or a required flow rate of the coolant for the first ECU 501 and the second ECU 502 based on the temperature of the first ECU 501 and the temperature of the second ECU 502, generate indication information of the required temperature and/or the required flow rate of the coolant, and report the indication information to the thermal management apparatus.

For another example, after obtaining the temperature of the first ECU 503, the temperature of the second ECU 504, and the temperature of the second ECU 505, the first ECU 503 may determine a required temperature and/or a required flow rate of the coolant for the first ECU 501, the second ECU 504, and the second ECU 505 based on the temperature of the first ECU 503, the temperature of the second ECU 504, and the temperature of the second ECU 505, generate indication information of the required temperature and/or the required flow rate of the coolant, and report the indication information to the thermal management apparatus.

Correspondingly, the thermal management apparatus may receive the indication information reported by the plurality of first ECUs, and control, based on the received plurality of pieces of indication information, the target temperature and/or the target flow rate of the coolant flowing out of the thermal management apparatus. For example, the thermal management apparatus 510 may receive indication information reported by the first ECU 501 and the first ECU 503, determine the target temperature and/or the target flow rate based on the indication information reported by the first ECU 501 and the first ECU 503, and control, based on the target temperature and/or the target flow rate, a temperature and/or a speed at which the coolant flows out of the thermal management apparatus.

As an example instead of a limitation, the thermal management apparatus may determine a plurality of required temperatures and/or a plurality of required flow rates based on the received plurality of pieces of indication information, and then determine a temperature with a smallest value in the plurality of required temperatures as the target temperature of the coolant flowing out of the thermal management apparatus, and/or determine a flow rate with a largest value in the plurality of required flow rates as the target flow rate of the coolant flowing out of the thermal management apparatus. This is not limited in embodiments of this application.

It may be understood that, when the second ECU is fastened to the first ECU, the first ECU may determine the required temperature and/or the required flow rate of the coolant based on the temperature of the first ECU and the temperature of the second ECU, and generate the indication information of the required temperature and/or the required flow rate of the coolant. When the second ECU is not fastened to the first ECU, the first ECU may determine a required temperature and/or a required flow rate of the coolant based on the temperature of the first ECU, and generate indication information of the required temperature and/or the required flow rate of the coolant. This is not limited in embodiments of this application.

In another possible implementation, the first ECU is further configured to report the temperature of the first ECU and the temperature of the second ECU to the thermal management apparatus. The thermal management apparatus is specifically configured to: receive temperatures reported by a plurality of first ECUs; and control the target temperature and/or the target flow rate based on the received plurality of temperatures.

For example, after obtaining the temperature of the first ECU and the temperature of the second ECU, the first ECU may report the temperature of the first ECU and the temperature of the second ECU to the thermal management apparatus.

For example, after obtaining the temperature of the first ECU 501 and the temperature of the second ECU 502, the first ECU 501 may report the temperature of the first ECU 501 and the temperature of the second ECU 502 to the thermal management apparatus.

For another example, after obtaining the temperature of the first ECU 503, the temperature of the second ECU 504, and the temperature of the second ECU 505, the first ECU 503 may report the temperature of the first ECU 503, the temperature of the second ECU 504, and the temperature of the second ECU 505 to the thermal management apparatus.

Correspondingly, the thermal management apparatus may receive the temperatures reported by the plurality of first ECUs, and control, based on the received temperatures, the target temperature and/or the target flow rate of the coolant flowing out of the thermal management apparatus. For example, the thermal management apparatus 510 may receive temperatures of the first ECU 501 and the first ECU 503 reported by the first ECU 501 and temperatures of the first ECU 503, the second ECU 504, and the second ECU 505 reported by the first ECU 503, determine the target temperature and/or the target flow rate based on these temperatures, and control, based on the target temperature and/or the target flow rate, a temperature and/or a speed at which the coolant flows out of the thermal management apparatus.

As an example instead of a limitation, the thermal management apparatus may control, based on a temperature with a largest value in the received plurality of temperatures, the target temperature and/or the target flow rate of the coolant flowing out of the thermal management apparatus. This is not limited in embodiments of this application.

It should be understood that the thermal management apparatus may include a processor and a receiving unit. The receiving unit may be configured to receive the indication information or the temperatures reported by the plurality of first ECUs. The processor may be configured to control, based on the indication information or the temperatures received by the receiving unit, the target temperature and/or the target flow rate of the coolant flowing out of the thermal management apparatus. In addition, the thermal management apparatus may further include a memory. The memory may be configured to store program instructions and/or data. The memory may be located inside the processor or outside the processor. This is not limited in embodiments of this application.

It may be understood that, when the second ECU is fastened to the first ECU, the first ECU may report the temperature of the first ECU and the temperature of the second ECU to the thermal management apparatus. When the second ECU is not fastened to the first ECU, the first ECU may report the temperature of the first ECU to the thermal management apparatus. This is not limited in embodiments of this application.

According to the foregoing solution, the fastening interfaces are provided on the ECU without the liquid cooling structure and the ECU with the liquid cooling structure, and the ECU without the liquid cooling structure and the ECU with the liquid cooling structure are fastened together through the fastening interfaces. In other words, the ECU without the liquid cooling structure and the ECU with the liquid cooling structure that are fastened together may be considered as a whole, to share the liquid cooling structure of the ECU with the liquid cooling structure. There is no need to introduce an additional independent liquid cooling plate, provided that the ECU with the liquid cooling structure is connected to a water path of the thermal management system. Introduction of additional independent liquid cooling plates is reduced in the water path of the thermal management system, so that complexity of the thermal management system can be reduced. In addition, the ECU without the liquid cooling structure and the ECU with the liquid cooling structure that are fastened together may be considered as a whole, and the first ECU and the second ECU may perform internal communication with each other through the communication channel. Based on this, there is no need for the second ECU to be in a communication connection to the thermal management apparatus, provided that the first ECU is in a communication connection to the thermal management apparatus. This can reduce complexity of a communication connection in the thermal management system to some extent, and further reduce difficulty in system maintenance. In addition, when complexity of a water path connection and the communication connection in the thermal management system is reduced, for an entire vehicle, space occupied by the thermal management system can be reduced. In addition, there is no need to purchase an additional independent liquid cooling plate, so that costs can be reduced.

An embodiment of this application further provides a terminal, and the terminal includes the control system described above.

Optionally, the terminal may include a vehicle.

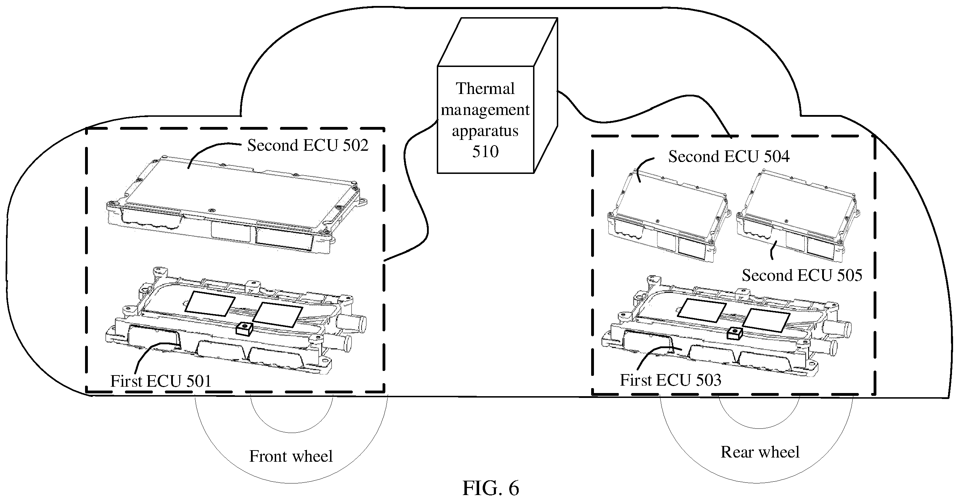

FIG. 6 is a diagram of a terminal according to an embodiment of this application.

A vehicle shown in FIG. 6 is an example of the terminal. As an example instead of a limitation, as shown in FIG. 6, the vehicle may include the control system shown in FIG. 5.

The terms "unit", "module", "assembly", and the like used in this application may be used to indicate a circuit-related entity, hardware, firmware, or a combination of hardware and software.

A person of ordinary skill in the art may be aware that, various illustrative logical blocks (illustrative logical blocks) and circuits described with reference to embodiments disclosed in this specification can be implemented by electronic hardware or a combination of computer software and electronic hardware. Whether these functions are performed by hardware or software depends on particular applications and design constraint conditions of the technical solutions. A person skilled in the art may use different methods to implement the described functions for each particular application, but it shall not be considered that the implementation goes beyond the scope of this application. In the several embodiments provided in this application, it should be understood that the disclosed apparatus, device, and method may be implemented in other manners. For example, the described apparatus embodiment is merely an example, and there may be another division manner during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or other forms.

The units described as separate components may or may not be physically separate, and components displayed as units may or may not be physical units, may be located in one position, or may be distributed on a plurality of units. Some or all of the units may be selected according to an actual requirement to achieve objectives of the solutions of embodiments.

In addition, functional units in embodiments of this application may be integrated into one processing unit, each of the units may exist alone physically, or two or more units are integrated into one unit.

In the foregoing embodiments, all or some of the functions of the functional units may be implemented by using software, hardware, firmware, or any combination thereof. When software is used to implement embodiments, all or some of the embodiments may be implemented in a form of computer program product. The computer program product includes one or more computer instructions (programs). When the computer program instructions (programs) are loaded and executed on a computer, all or some of the procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium (for example, a solid state disk (solid state disk, SSD)), or the like.

When the functions are implemented in a form of software functional unit and sold or used as an independent product, the functions may be stored in a computer-readable storage medium. Based on such an understanding, the technical solutions of this application essentially, or the part contributing to the conventional technology, or some of the technical solutions may be implemented in a form of software product. The computer software product is stored in a storage medium, and includes several instructions for instructing a computer device (which may be a personal computer, a server, a network device, or the like) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A control system, wherein the system comprises a first electronic control unit and a second electronic control unit, the first electronic control unit comprises a liquid cooling structure, and the second electronic control unit does not comprise a liquid cooling structure; and
the first electronic control unit and the second electronic control unit each comprise at least two fastening interfaces, the at least two fastening interfaces are configured to install fasteners, and the fasteners are configured to fasten the first electronic control unit and the second electronic control unit together.

2. The system according to claim 1, wherein the liquid cooling structure of the first electronic control unit comprises a cavity configured to contain a coolant, and a liquid inlet and a liquid outlet that communicate with the cavity; and the liquid cooling structure and the first electronic control unit are integrally formed.

3. The system according to claim 2, wherein the first electronic control unit further comprises at least one thermally conductive groove, the thermally conductive groove is located on an outer surface of the cavity, an opening of the thermally conductive groove faces the second electronic control unit, the thermally conductive groove is configured to contain a thermally conductive material, and the thermally conductive material is configured to conduct heat.

4. The system according to any one of claims 1 to 3, wherein the first electronic control unit and the second electronic control unit communicate with each other through a communication channel, and the communication channel comprises a controller area network CAN bus, a CAN with flexible data-rate FD bus, Ethernet, or a wireless network.

5. The system according to claim 4, wherein the first electronic control unit is configured to obtain a temperature of the second electronic control unit from the second electronic control unit through the communication channel.

6. The system according to any one of claims 1 to 5, wherein the system further comprises a thermal management apparatus, the liquid cooling structure of the first electronic control unit is connected to the thermal management apparatus, and the thermal management apparatus is configured to control a target temperature and/or a target flow rate of a coolant flowing out of the thermal management apparatus.

7. The system according to claim 6, wherein the first electronic control unit is further configured to report indication information of a required temperature and/or a required flow rate of the coolant to the thermal management apparatus based on a temperature of the first electronic control unit and the temperature of the second electronic control unit; and
the thermal management apparatus is specifically configured to:
receive indication information reported by a plurality of first electronic control units; and
control the target temperature and/or the target flow rate based on the received plurality of pieces of indication information.

8. The system according to claim 6, wherein the first electronic control unit is further configured to report a temperature of the first electronic control unit and the temperature of the second electronic control unit to the thermal management apparatus; and
the thermal management apparatus is specifically configured to:
receive temperatures reported by a plurality of first electronic control units; and
control the target temperature and/or the target flow rate based on the received plurality of temperatures.

9. A first electronic control unit, wherein the first electronic control unit comprises a liquid cooling structure, the first electronic control unit comprises at least two fastening interfaces for installing fasteners, and the fasteners are configured to fasten the first electronic control unit and a second electronic control unit that does not comprise a liquid cooling structure together.

10. The first electronic control unit according to claim 9, wherein the liquid cooling structure comprises a cavity configured to contain a coolant, and a liquid inlet and a liquid outlet that communicate with the cavity; and the liquid cooling structure and the first electronic control unit are integrally formed.

11. The first electronic control unit according to claim 10, wherein the first electronic control unit further comprises at least one thermally conductive groove, the thermally conductive groove is located on an outer surface of the cavity, the thermally conductive groove is configured to contain a thermally conductive material, and the thermally conductive material is configured to conduct heat.

12. The first electronic control unit according to any one of claims 9 to 11, wherein the first electronic control unit is configured to obtain a temperature of the second electronic control unit.

13. A second electronic control unit, wherein the second electronic control unit does not comprise a liquid cooling structure, the second electronic control unit comprises at least two fastening interfaces for installing fasteners, and the fasteners are configured to fasten the second electronic control unit and a first electronic control unit comprising a liquid cooling structure together.

14. A terminal, wherein the terminal comprises the control system according to any one of claims 1 to 8.

15. The terminal according to claim 14, wherein the terminal comprises a vehicle.
